# EUROPEAN PATENT SPECIFICATION

(11) **EP 4 088 034 B1**
(45) Date of publication and mention of the grant of the patent: **05.03.2025**
(21) Application number: 21700335.9
(22) Date of filing: 07.01.2021
(51) Int. Cl.: F04D 19/04, F04D 29/54

(54) **VACUUM PUMP, VACUUM PUMP SET FOR EVACUATING A SEMICONDUCTOR PROCESSING CHAMBER AND METHOD OF EVACUATING A SEMICONDUCTOR PROCESSING CHAMBER**
VAKUUMPUMPE, VAKUUMPUMPENAGGREGAT ZUR EVAKUIERUNG EINER HALBLEITERVERARBEITUNGSKAMMER SOWIE VERFAHREN ZUR EVAKUIERUNG EINER HALBLEITERVERARBEITUNGSKAMMER
POMPE À VIDE, DISPOSITIF DE POMPE À VIDE POUR ÉVACUER UNE CHAMBRE DE TRAITEMENT DE SEMI-CONDUCTEUR ET MÉTHODE D'ÉVACUATION D'UNE CHAMBRE DE TRAITEMENT DE SEMI-CONDUCTEUR

(30) Priority: 09.01.2020 GB 202000297
(43) Date of publication of application: 16.11.2022
(73) Proprietor: Edwards Limited, Burgess Hill, Sussex RH15 9TW (GB)
(72) Inventor: SCHOFIELD, Nigel Paul, Burgess Hill Sussex RH15 9TW (GB)
(74) Representative: Totman, Clare Elizabeth
(86) International application number: PCT/GB2021/050035
(87) International publication number: WO 2021/140329

(56) References cited:
- EP-A1- 3 521 629
- EP-A1- 3 530 951
- US-A1- 2015 037 137

## Description

### FIELD OF THE INVENTION

The field of the invention relates to vacuum pumps and to methods of evacuating a semiconductor processing chamber.

### BACKGROUND

Vacuum pumps are designed and configured to operate effectively across a particular pressure range. No one pump can operate effectively across all pressure ranges.

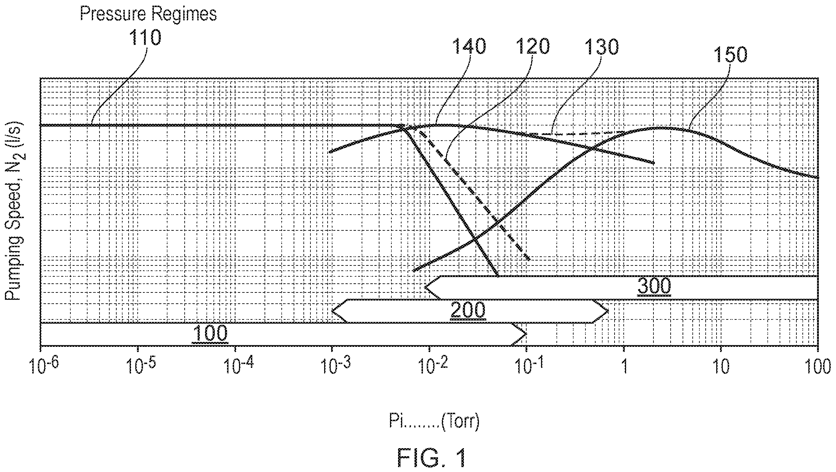

Figure 1 is a graph showing pumping speed against pressure and illustrates the flow regimes that operate across different pressure ranges and the pumps that are effective at pumping in these flow regimes and pressure ranges. Thus, at high vacuums in the molecular flow regime 100 turbomolecular pumps 110 are effective, while at lower vacuums in the viscous flow regime 300 rough pumps 150 such as roots-blower pumps are effective. In the transitional flow regime 200 at pressures where both molecular and viscous flow occur drag pumps 140 may be used. Compound pumps 120 which are formed as a blade and drag combination extend from the molecular flow to the higher vacuum portion of the transition flow regime.

The pumping mechanism of a conventional drag pumps requires the rotor to rotate close to the stator in order to optimise the compression ratio of the pump and this limits the depth of the stator channel, which in turn limits the pumping capacity of a conventional drag pump.

There is an increasing requirement to operate semiconductor processing chambers over a range of pressures that can be too high for a turbo pump to sustain without overheating, (typically pressures above 0.05 mbar), but are too low for a remotely mounted roots blower to be effective due to the conductance of the connection pipe, (typically less than 0.2 mbar).

US2015037137A1 discloses a vacuum pump as known in the art. The stator discs comprise holes. A first perforated disk is disposed nearest to an inlet of the pump and a second perforated disk is disposed nearest to an output of the pump. The first perforated disk can have a higher or lower transparency compared to the second perforated disk. This arrangement can be utilised if the desired inlet pressure is in the molecular flow pressure regime and the outlet pressure is in the transitional or viscous flow pressure regime.

EP3521629 and EP3530951 disclose vacuum pumps as known in the art. The stator discs comprise holes.

It would be desirable to provide a pump that had a reasonable capacity and was effective at pumping at the pressures required for some semiconductor processing chambers.

### SUMMARY

A first aspect provides a vacuum pump for mounting to a semiconductor processing chamber to evacuate said chamber to pressures between 1 mbar and 5 X10⁻² mbar, said vacuum pump comprising: a rotor rotatably mounted within a stator; said rotor comprising a plurality of angled blades arranged along a helical path from an inlet to an outlet; said stator comprising a plurality of perforated elements arranged to intersect said helical path, said perforations allowing gas molecules travelling along said helical path to pass through said perforated elements; said rotor being mounted on a magnetically levitated bearing; and said perforated elements located towards the inlet of said vacuum pump comprising a transparency of more than 40% and said perforated elements located towards the outlet of said vacuum pump having a transparency of more than 30%, wherein the transparency of said plurality of perforated elements reduces towards said outlet.

Transparency is the ratio of the total area of the perforations of the perforated element intersecting a gas flow channel to the total area of the element intersecting the given flow path channel.

Providing a pump that is able to pump in the pressure range of a conventional drag pump, but that also has a high transparency enables the pump to effectively pump at a relatively high pumping speed at the lower pressures, while at the higher pressures, the transparency of the pump allows effective pumping when the pump is backed by another pump such as a roots blower. The transparency does reduce compression particularly at the higher pressures, but this is acceptable as at these pressures a backing pump, even when connected from a remote location, can pump effectively, provided that the transparency of any pump between the backing pump and the chamber is not so high that it unduly impedes the flow. Thus, a pump that pumps effectively in the transitional flow regime 200 of Figure 1 and may be seen as providing the effect of a drag plus pump 130.

As the gas flows through the pump it is compressed and this compression means that the open or transparent area can be reduced towards the outlet.

In some embodiments, said perforated elements located towards an inlet of said vacuum pump comprise a transparency of more than 50% and said perforated elements located towards an outlet of said vacuum pump comprise a transparency of more than 40%.

In some embodiments, said rotor and stator are formed of at least one of stainless steel and aluminium.

An advantage of forming at least one of the rotor and stator from stainless steel is that stainless steel can operate at relatively high temperatures and this enables the pump to operate at elevated temperatures. Where the pump is pumping from a semiconductor processing chamber this can be advantageous as the higher temperatures reduce the amount of deposition of particles within the pump.

Aluminium is not able to operate at such high temperatures, however it does have the advantages of high thermal conductivity and helps conduct heat away from the interior of the pump.

In some embodiments, said rotor is formed of stainless steel and said perforated elements of aluminium.

The rotor within a pump will heat up to higher temperatures than the stator as it is easier to cool the stator than it is the rotating rotor. Thus, it may be advantageous to form the rotor of stainless steel which is able to operate at relatively high temperatures while forming the stator of aluminium which has a higher thermal conductivity and can act to conduct heat away from the interior of the pump.

In embodiments where the stator comprises perforated elements that extend into the pump and through which the gas travels it is important that these do not overheat as this might lead to them buckling. Any deformation of these elements can be problematic as clearances between the rotor and these stator elements are generally fairly tight to provide effective pumping, and any buckling may cause clashes between the rotor and stator elements. Forming the perforated elements of aluminium allows heat to be conducted away from the central portions of the stator towards the edges which are cooler and helps reduce the temperature rise of the stator and mitigates against such buckling or deformation.

In some embodiments, at least one of said rotor and stator comprise a coating of a high emissivity.

As noted previously, removing at least some of the heat from the pump to avoid it overheating is desirable and providing coatings of high emissivity on the rotor and/or the stator can help reduce the temperature rises.

In some embodiments, said vacuum pump is configured to operate at a volumetric speed of between 300 and 1200 litres per second.

One advantage of a vacuum pump according to an embodiment, which makes it particularly effective for evacuating semiconductor processing chambers is its relatively high pumping speed at relatively low pressures. This is in contrast to many conventional drag pumps. In this regard the absence of the channels of a restricted depth between the rotor and stator that are present in a conventional drag pump allows pumping speeds to be increased, although it does reduce the compression ratio, particularly at the higher pressures of its operating range.

However, as backing pumps such as roots-blower pumps may provide effective compression at these "higher" pressures this reduction in compression is acceptable.

In some embodiments, said vacuum pump comprises an inlet conduit extending from an inlet of said vacuum pump and configured to connect to said semiconductor processing chamber, said inlet conduit having a length of less than 2m, preferably less than 1m.

A further advantage of a vacuum pump according to an embodiment is that it is mounted on magnetically levitated bearings. This allows the vacuum pump to be placed within the semiconductor fab and close to the semiconductor processing chamber when evacuating a semiconductor processing chamber. This allows the vacuum pump to be connected to the semiconductor processing chamber by a relatively short conduit, in some embodiments the connecting conduit is less than 2m preferable less than 1m. When pumping at low pressures having a long conduit between the pump and the chamber to be evacuated significantly reduces the pumping efficiency and is one reason why many conventional vacuum pumps that do not have magnetically levitated bearings, and thus need to be remote from the semiconductor processing chamber, such as root blowers are not appropriate for pumping these chambers to low pressures.

In some embodiments, said blades of said rotor at an inlet stage of said pump are wider than said blades of said rotor in other stages of said pump.

In some cases it may be advantageous to extend the width of the blades at the inlet stage of the pump to capture more gas molecules at the inlet of the pump and send them into the pumping channels to progress through the pump. The inlet of the pump sees the lowest pressure and it is at this point that the capture of molecules is the most challenging.

In some embodiments, said stator further comprises a cylindrical surface formed by a stack of rings each having a cylindrical inner surface, said plurality of perforated elements being mounted on respective rings, such that said plurality of perforated elements form a plurality of perforated discs intersecting said helical path at different axial positions.

The helical channel may be within a cylindrical surface with the rotor rotating within this surface. The cylindrical surface may be formed of a stack of rings between which the perforated discs of the stator may be mounted at different axial positions. Thus, the helical path is intercepted at different axial positions by the perforated discs as the gas flows through the pump. The axis concerned here is the axis of rotation of the rotor.

A second aspect provides a set of vacuum pumps for evacuating a semiconductor processing chamber, comprising a vacuum pump according to any preceding claim and a roots blower and primary vacuum pump arranged as a backing pump for said vacuum pump.

A set of vacuum pumps including a vacuum pump according to a first aspect backed by a roots blower and primary pump provides an effective pumping arrangement for a vacuum chamber such as a semiconductor processing chamber to be evacuated to a pressure of between 1 mbar and 5 X10⁻² mbar. Such pressures are appropriate for semiconductor processes including semiconductor device fabrication processes such as ALD (atomic layer deposition) processes. The vacuum pump according to a first aspect provides a relatively high pumping speed at relatively low pressures, but only has a modest compression ratio, particularly at the higher pressures of its operating range. However, when used in conjunction with a roots-blower pump, this combination can provide the required compression across the pressure range, owing to the properties of the roots blower and the high transparency of the vacuum pump of a first aspect. In this regard the constraint for effective operation of the roots blower in the evacuation of a semiconductor vacuum chamber is the length of the conduit required as the roots-blower cannot be mounted within the clean room. However, using it in conjunction with a vacuum pump of a first aspect that can be mounted in the clean room/fab and which evacuates effectively at the lower pressures of the operational range, provides a combination of pumps which can effectively evacuate a semiconductor processing chamber across the full pressure range of 1 mbar to 5 X10⁻² mbar.

In some embodiments, the set of vacuum pumps further comprises a conduit of less than 2m long, preferably less than 1m for connecting said vacuum pump to said semiconductor processing chamber and a longer conduit for connecting said vacuum pump to said roots blower and primary pump such that said roots blower and primary pump are located remotely from said semiconductor processing chamber. The longer conduit is there to allow the roots blower pump to be situated remotely from the vacuum chamber and the clean room, and in some embodiments is at least 8m long.

A third aspect provides a method of evacuating a semiconductor processing chamber said method comprising: locating a vacuum pump according to the first aspect within a semiconductor fab and attaching said vacuum pump to a semiconductor processing chamber by a conduit of less than 2m length; locating a roots blower and primary pump in a position remote from the semiconductor fab and attaching an outlet of said vacuum pump to an inlet of said roots blower pump via a longer conduit; operating said vacuum pumps to evacuate said semiconductor processing chamber to a vacuum of between 1 mbar and 5 X10⁻² mbar.

Further particular and preferred aspects are set out in the accompanying independent and dependent claims. Features of the dependent claims may be combined with features of the independent claims as appropriate, and in combinations other than those explicitly set out in the claims.

Where an apparatus feature is described as being operable to provide a function, it will be appreciated that this includes an apparatus feature which provides that function or which is adapted or configured to provide that function.

### BRIEF DESCRIPTION OF THE DRAWINGS

Embodiments of the present invention will now be described further, with reference to the accompanying drawings, in which:
Figure 1 shows a graph illustrating the different pressure ranges that are effectively pumped by different types of pumps;
Figure 2 shows a semiconductor processing chamber and a set of pumps for evacuating the semiconductor processing chamber according to an embodiment;
Figure 3 shows a vacuum pump of a pump according to an embodiment;
Figure 4 shows a rotor for a vacuum pump according to an embodiment;
Figure 5 schematically shows gas flow within a pump according to an embodiment; and
Figure 6 shows a perforated element portion of the stator according to an embodiment.

### DESCRIPTION OF THE EMBODIMENTS

Before discussing the embodiments in any more detail, first an overview will be provided.

Drag pumps typically have a relatively low volumetric speed say <100 I/s on a large turbo pump due to the narrow passages that must be used. The 'Schofield Drag Pump' described in patent application US2015/0037137 mitigates this speed limitation by passing gas through one of the drag surfaces and thereby enables a much higher capacity machine to be designed. It may provide pumping capacity in the region of 600l/s.

The inventor of this drag pump recognised that the properties of the drag pump make it particularly effective for evacuating a semiconductor processing chamber to pressures between 1 mbar and 5 ×10⁻² mbar. In particular, were it to be designed with sufficient transparency then it could provide effective pumping at the lower pressures while at higher pressures where it might not be so effective, the transparency would ensure that the flow to a backing pump such as a roots blower was not be unduly impeded or restricted, allowing a combination of pumps to provide effective pumping across a wide pressure range.

Use of this type of drag pump enables a semiconductor processing chamber to be effectively pumped between 1 mbar and 5 X10⁻² mbar. In embodiments, the pump is backed by a conventional dry pump and roots blower combination mounted remotely, typically in the basement of the semiconductor fab.

A further feature of this drag pump design is that it may be formed from high strength stainless steel, thus enabling the rotor to be used at much higher temperatures than were it made from aluminium. This is important to prevent the condensation of semiconductor by-products within the pump. It is very difficult to make a turbo pump from stainless steel due to the small blade geometry, particularly in the exhaust sections.

A further feature to improving pumping speeds and transparency is that in some embodiments the exhaust is not unduly restricted, such that the exhaust of the Schofield pump has a size that is similar to that of the inlet to the roots blower pump. That is within 20% of the inlet size, the conduit linking the two also being of a similar size.

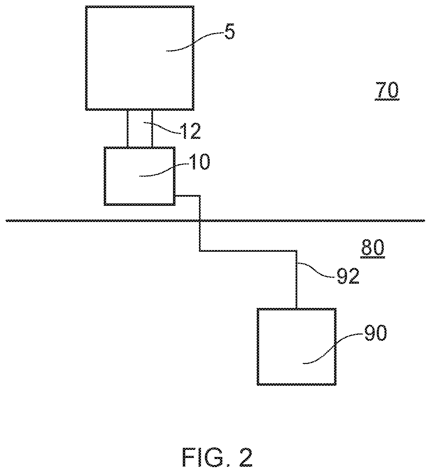

Figure 2 shows semiconductor processing chamber 5 located within a clean room or semiconductor fab and with a vacuum pump 10 according to an embodiment attached to the semiconductor processing chamber via a relatively short conduit 12. The vacuum pump 10 is a Schofield pump and has a rotor mounted on magnetically levitated bearings such that it may be located within the clean room and be connected to the semiconductor processing chamber 5 by the relatively short and wide conduit 12.

Remote from the vacuum pump 10 and semiconductor processing chamber 5 is a backing pump combination 90 which comprises a roots blower and a primary pump. These are located in the basement 80 remote from the clean room 70 as their operation generates vibrations, the bearings of the pumps 90 not being magnetically levitated. For this reason the conduit 92 between the backing pump combination 90 and the Schofield pump 10 is relatively long and this affects the effectiveness of the backing pump 90 particularly at low pressures.

The combination of the Schofield pump 10 with relatively high pumping capacity attached close to the semiconductor processing chamber 5 and with the backing pumps 90 which can pump effectively at the higher pressures of the effective pumping range provide a set of pumps which pump effectively in the transitional flow range and particularly in the higher pressure sides of this flow range providing the effective pumping indicated by the dotted line shown as "drag plus" in Figure 1.

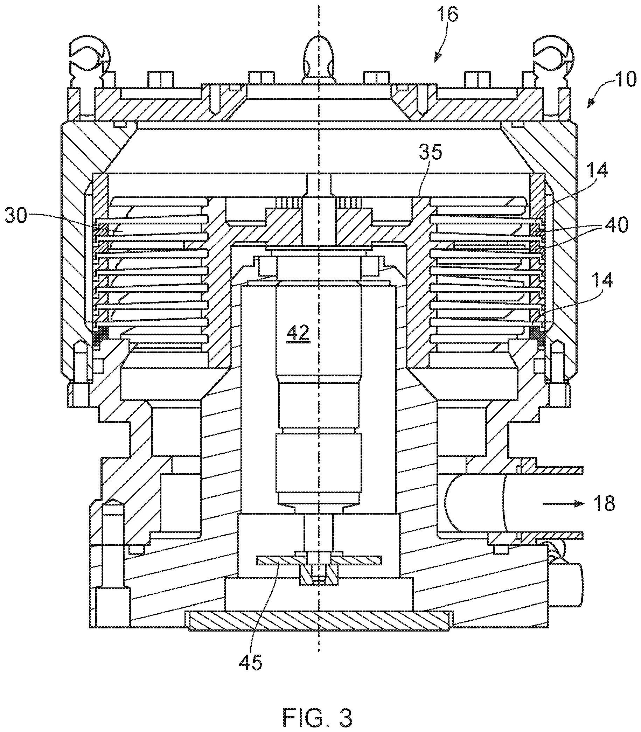

The Schofield vacuum pump 10 is shown schematically in Figure 3. Vacuum pump 10 comprises a plurality of perforated stator elements 14 which comprise perforated discs through which the gas flows from an inlet 16 to an exhaust 18. The perforated discs are mounted at different axial positions on cylindrical rings 40 and extend between rows of blades 30 of rotor 35 which blades 30 form a helical path from the inlet 16 to the outlet 18. The helical rotor 35 is mounted on shaft 42 and rotates during operation. Shaft 42 is mounted on magnetically levitated bearings 45.

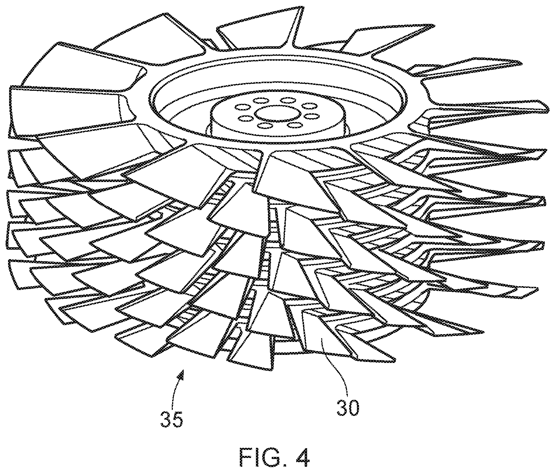

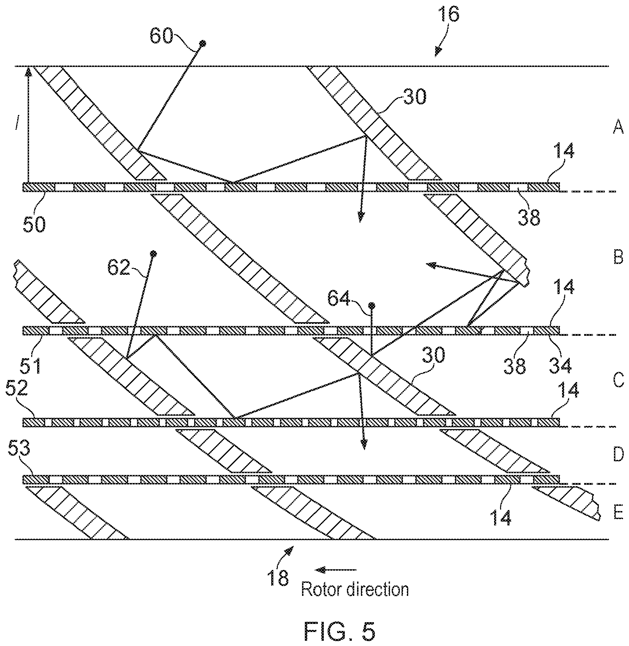

Figure 4 shows a further view of rotor 35 showing the helical blades 30. As can be seen the helical rotor blades 30 form a helical path. Rotation of rotor 35 imparts momentum to gas molecules that the blades contact, and sends them towards the outlet 18 through the perforated elements 14 (see Figure 3). Impact with the non-perforated portions of the stator disks slows the gas molecules and provides the drag of the drag pump, pulling the molecule trajectory towards the output. Figure 5 shows some example molecule trajectories.

Figure 5 schematically shows a circumferential cross section of a portion of the mechanism of the pump and illustrates the operational principles. When in operation, the rotor having the angled blades 30 is rotated at a relatively high speed. The principles of operation show the components of the pump in a linear manner with the rotational movement of the rotor shown as a linear movement indicated by the arrow.

In this embodiment, there are four stator perforated discs 14 dividing the pump into five stages A to E. Stage A is upstream of a first stator element 50, with successive downstream stages being separated by successive stator elements 51 - 53.

The angled rotor blades 30 form a helical flow path channel from an inlet 16 to an outlet 18 with the perforated disk elements 14 intersecting the flow path channel. Figure 5 shows some different possible gas molecule paths. A first path is illustrated by arrow 60. The molecule enters the inlet of the pump which operates at high vacuum pressure. It strikes the rotor blade 30 and momentum is imparted to the molecule by the relative movement of the rotor and the molecule is deflected towards the stator element where it strikes a solid part and is slowed. Next, the molecule strikes the underside surface of the rotor blade 30 and is again directed towards the stator element where in this case the molecule's path interacts with a disk perforation 38 allowing the molecule to pass through the intersecting disk into the next section of the pump, namely section B as illustrated.

A second path of another molecule is illustrated by arrow 62. Here, the molecule's path passes through a perforation on the rotor allowing the molecule to progress from section B to Section C where it then interacts with rotor blade 30 and is emitted from the surface towards the stator element 51 through which it has just passed. Here, it interacts with the downstream surface of the stator element and is retained within section C, as a result. Its path then continues onto the third stator element 52, from here to the opposite sidewall of the channel, namely underside of rotor blade 30 and then through a perforation of the third stator into section D. Thus, momentum can be transferred to gas molecules by either sidewalls of the channel formed by the upper and lower surfaces of the rotor blades, or by both surfaces.

A third path of a different molecule is illustrated by arrow 64. Here, the molecule passes from Section B into Section C via a perforation in the second stator 51 where it is deflected by the rotor blade 30 and returns to section B through a perforation 38 of the stator and contacts the underside of the rotor blade 30.

Thus, gas molecules migrating into the inlet of the pump encounter a surface of the rotor blade 30 or perforated stator disk 14. Some molecules pass through a perforation 38 and strike a surface of the rotor. Momentum of the gas molecule leaving the surface of the rotor is influenced by the rotary motion of the rotor and it is likely that the molecule has momentum transferred to it having a major component in the direction of the rotor's movement. As a result, the majority of molecules striking and leaving the rotor's surfaces are urged towards the exhaust.

In the example of Figure 5 the compression of gas increases from stage A to stage E with an increasing reduction of rotor spacing towards stage E and/or increased angle of inclination of the sidewalls with respect to the rotor axis. This can assist with maintaining pump efficiency as the gas molecules become compressed towards the outlet. In other embodiments, the stator disc separation and rotor blade angles are constant in the different stages, however, the inlet stage may have rotor blades of an increased width to capture more gas molecules at the high vacuum inlet.

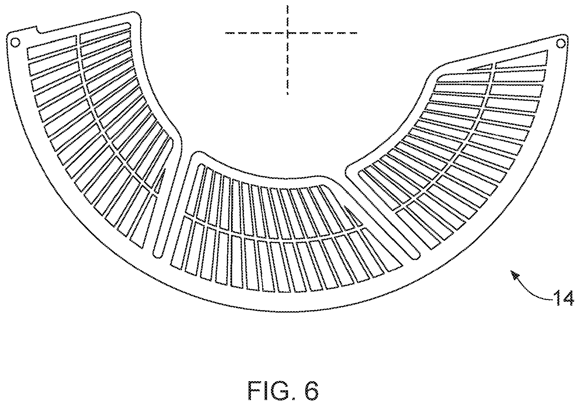

Figure 6 shows a perforated stator element 14. In this embodiment the perforated stator disc, is formed of two elements which are joined together to form the disc. The perforated stator disc has a transparency of more than 30% and in preferred embodiments, comprises radially extending walls running between the perforations in order to conduct heat from a central portion to an outer portion, thereby limiting the heat increase of the central ring of the disc. Furthermore, there are indents provided in the central ring of the disc and in some cases gaps between the two elements forming the disc and these provide space for the inner ring to expand into thereby reducing the chances that expansion will cause buckling of the ring with the associated axial movement which can cause clashing between the rotor and stator.

Although illustrative embodiments of the invention have been disclosed in detail herein, with reference to the accompanying drawings, it is understood that the invention is not limited to the precise embodiment and that various changes and modifications can be effected therein by one skilled in the art without departing from the scope of the invention which is defined by the appended claims.

### REFERENCE SIGNS

- 5: vacuum chamber
- 10: vacuum pump
- 12, 92: conduit
- 14: perforated stator element
- 16: inlet
- 18: outlet
- 30: rotor blades
- 35: rotor
- 38: perforations
- 40: rings
- 42: shaft
- 45: bearings
- 50, 51, 52, 53: perforated discs
- 60, 62, 64: molecular paths
- 70: clean room
- 80: basement
- 90: backing pump set
- 100: molecular flow
- 110: turbomolecular pump
- 120: compound pump
- 130: drag plus pump
- 140: drag pump
- 150: rough pump
- 200: transitional flow
- 300: viscous flow

## Claims

1. A vacuum pump (10) for mounting to a semiconductor processing chamber (5) to evacuate said chamber to pressures between 1 mbar and 5 X10⁻² mbar, said vacuum pump comprising:
a rotor (35) rotatably mounted within a stator;
said rotor comprising a plurality of angled blades (30) arranged along a helical path from an inlet (16) to an outlet (18);
said stator comprising a plurality of perforated elements (14) arranged to intersect said helical path, said perforations allowing gas molecules travelling along said helical path to pass through said perforated elements;
said rotor being mounted on a magnetically levitated bearing (45); **characterised in that**
said perforated elements located towards the inlet of said vacuum pump comprise a transparency of more than 40% and said perforated elements located towards the outlet of said vacuum pump comprise a transparency of more than 30%, and **in that** the transparency of said plurality of perforated elements reduces towards said outlet.

2. A vacuum pump according to claim 1, wherein said perforated elements located towards an inlet of said vacuum pump comprise a transparency of more than 50% and said perforated elements located towards an outlet of said vacuum pump comprise a transparency of more than 40%.

3. A vacuum pump according to claim 1, wherein said rotor and stator are formed of at least one of stainless steel and aluminium.

4. A vacuum pump according to claim 3, wherein said rotor is formed of stainless steel and said perforated elements of aluminium.

5. A vacuum pump according to any preceding claim, wherein at least one of said rotor and stator comprise a coating of a high emissivity.

6. A vacuum pump according to any preceding claim, said vacuum pump being configured to operate at a volumetric speed of between 300 and 1200 litres per second.

7. A vacuum pump according to any preceding claim, said vacuum pump comprising an inlet conduit (12) extending from an inlet of said vacuum pump and configured to connect to said semiconductor processing chamber, said inlet conduit having a length of less than 2m, preferably less than 1 m.

8. A vacuum pump according to any preceding claim, said blades of said rotor at an inlet stage of said pump being wider than said blades of said rotor in other stages of said pump.

9. A vacuum pump according to any preceding claim, said stator further comprising a cylindrical inner surface formed by a stack of rings (40) each having a cylindrical inner surface, said plurality of perforated elements being mounted on respective rings, such that said plurality of perforated elements form a plurality of perforated discs intersecting said helical path at different axial positions.

10. A set of vacuum pumps for evacuating a semiconductor processing chamber, comprising a vacuum pump according to any preceding claim and a roots blower and primary vacuum pump arranged as a backing pump combination for said vacuum pump.

11. A set of vacuum pumps according to claim 10, further comprising a conduit of less than 2m long, preferably less than 1m for connecting said vacuum pump to said semiconductor processing chamber and a longer conduit for connecting said vacuum pump to said roots blower and primary pump such that said roots blower and primary pump are located remotely from said semiconductor processing chamber.

12. A method of evacuating a semiconductor processing chamber said method comprising:
locating a vacuum pump according to any of claims 1 to 9 within a semiconductor fab and attaching said vacuum pump to a semiconductor processing chamber by a conduit of less than 2m length;
locating a roots blower and primary pump in a position remote from the semiconductor fab and attaching an outlet of said vacuum pump to an inlet of said roots blower pump via a longer conduit;
operating said vacuum pumps to evacuate said semiconductor processing chamber to a vacuum of between 1 mbar and 5 X10⁻² mbar.

## Patentansprüche

1. Vakuumpumpe (10) zum Montieren an einer Halbleiterverarbeitungskammer (5) zum Evakuieren der Kammer auf Drücke zwischen 1 mbar und 5 × 10⁻² mbar, wobei die Vakuumpumpe Folgendes umfasst:
einen Rotor (35), der drehbar innerhalb eines Stators montiert ist;
wobei der Rotor eine Vielzahl abgewinkelter Flügel (30) umfasst, die entlang eines schraubenförmigen Pfades von einem Einlass (16) zu einem Auslass (18) angeordnet sind;
wobei der Stator eine Vielzahl perforierter Elemente (14) umfasst, die angeordnet sind,
um den schraubenförmigen Pfad zu schneiden, wobei die Perforationen erlauben, dass sich Gasmoleküle entlang des schraubenförmigen Pfades bewegen, um die perforierten Elemente zu durchlaufen;
wobei der Rotor an einem magnetisch freischwebenden Lager (45) montiert ist;
**dadurch gekennzeichnet, dass**
die perforierten Elemente, die sich in Richtung des Einlasses der Vakuumpumpe befinden, eine Transparenz von mehr als 40 % umfassen, und die perforierten Elemente,
die sich in Richtung des Auslasses der Vakuumpumpe befinden, eine Transparenz von mehr als 30 % umfassen,
und dadurch, dass sich die Transparenz der Vielzahl perforierter Elemente in Richtung des Auslasses verringert.

2. Vakuumpumpe nach Anspruch 1, wobei die perforierten Elemente, die sich in Richtung eines Einlasses der Vakuumpumpe befinden, eine Transparenz von mehr als 50 % umfassen, und die perforierten Elemente, die sich in Richtung eines Auslasses der Vakuumpumpe befinden, eine Transparenz von mehr als 40 % umfassen.

3. Vakuumpumpe nach Anspruch 1, wobei der Rotor und Stator aus Edelstahl und/oder Aluminium ausgebildet sind.

4. Vakuumpumpe nach Anspruch 3, wobei der Rotor aus Edelstahl ausgebildet ist und die perforierten Elemente aus Aluminium.

5. Vakuumpumpe nach einem der vorangehenden Ansprüche, wobei der Rotor und/oder der Stator eine Beschichtung mit einer hohen Emissivität umfasst.

6. Vakuumpumpe nach einem der vorangehenden Ansprüche, wobei die Vakuumpumpe dazu konfiguriert ist, bei einer volumetrischen Geschwindigkeit zwischen 300 und 1200 Litern pro Sekunde zu arbeiten.

7. Vakuumpumpe nach einem der vorangehenden Ansprüche, wobei die Vakuumpumpe eine Einlassleitung (12) umfasst, die sich von einem Einlass der Vakuumpumpe erstreckt und dazu konfiguriert ist, sich mit der Halbleiterverarbeitungskammer zu verbinden, wobei die Einlassleitung eine Länge von weniger als 2 m, vorzugsweise weniger als 1 m, aufweist.

8. Vakuumpumpe nach einem der vorangehenden Ansprüche, wobei die Flügel des Rotors in einer Einlassstufe der Pumpe breiter als die Flügel des Rotors in anderen Stufen der Pumpe sind.

9. Vakuumpumpe nach einem der vorangehenden Ansprüche, wobei der Stator ferner eine zylindrische Innenfläche umfasst, ausgebildet durch einen Stapel von Ringen (40), die jeweils eine zylindrische Innenfläche aufweisen, wobei die Vielzahl perforierter Elemente an entsprechenden Ringen montiert ist, so dass die Vielzahl perforierter Elemente eine Vielzahl perforierter Scheiben ausbildet, die den schraubenförmigen Pfad an verschiedenen axialen Positionen schneiden.

10. Vakuumpumpenaggregat zum Evakuieren einer Halbleiterverarbeitungskammer, umfassend eine Vakuumpumpe nach einem der vorangehenden Ansprüche und ein Rootsgebläse und eine primäre Vakuumpumpe, angeordnet als eine unterstützende Pumpenkombination für die Vakuumpumpe.

11. Vakuumpumpenaggregat nach Anspruch 10, ferner umfassend eine Leitung von weniger als 2 m Länge, vorzugsweise weniger als 1 m, zum Verbinden der Vakuumpumpe mit der Halbleiterverarbeitungskammer, und eine längere Leitung zum Verbinden der Vakuumpumpe mit dem Rootsgebläse und der primären Pumpe, so dass sich das Rootsgebläse und die primäre Pumpe von der Halbleiterverarbeitungskammer entfernt befinden.

12. Verfahren zum Evakuieren einer Halbleiterverarbeitungskammer, wobei das Verfahren umfasst:
Anordnen der Vakuumpumpe nach einem der Ansprüche 1 bis 9 innerhalb einer Halbleiter-Fab und Anbringen der Vakuumpumpe an einer
Halbleiterverarbeitungskammer durch eine Leitung von weniger als 2 m Länge;
Anordnen eines Rootsgebläses und einer primären Pumpe in einer von der Halbleiter-Fab entfernten Position und Anbringen eines Auslasses der Vakuumpumpe an einem Einlass der Rootsgebläsepumpe über eine längere Leitung;
Betreiben der Vakuumpumpen zum Evakuieren der Halbleiterverarbeitungskammer auf ein Vakuum zwischen 1 mbar und 5 × 10⁻² mbar.

## Revendications

1. Pompe à vide (10) destinée à être montée sur une chambre de traitement de semi-conducteurs (5) pour vider ladite chambre à des pressions comprises entre 1 mbar et 5 × 10⁻² mbar, ladite pompe à vide comprenant :
un rotor (35) monté mobile en rotation à l'intérieur d'un stator ;
ledit rotor comprenant une pluralité d'ailettes inclinées (30) disposées le long d'un trajet hélicoïdal allant d'un orifice d'entrée (16) à un orifice de sortie (18) ;
ledit stator comprenant une pluralité d'éléments perforés (14) disposés pour couper ledit trajet hélicoïdal, lesdites perforations permettant à des molécules de gaz de parcourir le trajet hélicoïdal pour traverser lesdits éléments perforés ;
ledit rotor étant monté sur un palier à lévitation magnétique (45) ;
**caractérisée en ce que**
lesdits éléments perforés situés en direction de l'orifice d'entrée de ladite pompe à vide ont une transparence supérieure à 40 % et lesdits éléments perforés situés en direction de l'orifice de sortie de ladite pompe à vide ont une transparence supérieure à 30 %,
et **en ce que** la transparence des éléments perforés de ladite pluralité d'éléments perforés diminue en direction dudit orifice de sortie.

2. Pompe à vide selon la revendication 1, dans laquelle lesdits éléments perforés situés en direction d'un orifice d'entrée de ladite pompe à vide ont une transparence supérieure à 50 % et lesdits éléments perforés situés en direction d'un orifice de sortie de ladite pompe à vide ont une transparence supérieure à 40 %.

3. Pompe à vide selon la revendication 1, dans laquelle ledit rotor et ledit stator sont formés d'au moins l'un de l'acier inoxydable et de l'aluminium.

4. Pompe à vide selon la revendication 3, dans laquelle ledit rotor est formé d'acier inoxydable et lesdits éléments perforés sont formés d'aluminium.

5. Pompe à vide selon l'une quelconque des revendications précédentes, dans laquelle au moins l'un dudit rotor et dudit stator comprend un revêtement à haute émissivité.

6. Pompe à vide selon l'une quelconque des revendications précédentes, ladite pompe à vide étant configurée pour fonctionner à un régime volumétrique compris entre 300 et 1200 litres par seconde.

7. Pompe à vide selon l'une quelconque des revendications précédentes, ladite pompe à vide comprenant un conduit d'entrée (12) s'étendant d'un orifice d'entrée de ladite pompe à vide et configuré pour être raccordé à ladite chambre de traitement de semi-conducteurs, ledit conduit d'entrée ayant une longueur inférieure à 2 m, de préférence inférieure à 1 m.

8. Pompe à vide selon l'une quelconque des revendications précédentes, lesdites ailettes dudit rotor au niveau d'un étage d'entrée de ladite pompe étant plus larges que lesdites ailettes dudit rotor dans d'autres étages de ladite pompe.

9. Pompe à vide selon l'une quelconque des revendications précédentes, ledit stator comprenant en outre une surface intérieure cylindrique formée par un empilement de bagues (40) ayant chacune une surface intérieure cylindrique, les éléments perforés de ladite pluralité d'éléments perforés étant montés sur des bagues respectives, de sorte que les éléments perforés de ladite pluralité d'éléments perforés forment une pluralité de disques perforés coupant ledit trajet hélicoïdal à des positions axiales différentes.

10. Ensemble de pompes à vide destiné à vider une chambre de traitement de semi-conducteurs, comprenant une pompe à vide selon l'une quelconque des revendications précédentes ainsi qu'une pompe à soufflante Roots et une pompe à vide primaire prévues en tant que combinaison de pompes de secours de ladite pompe à vide.

11. Ensemble de pompes à vide selon la revendication 10, comprenant en outre un conduit de longueur inférieure à 2 m, de préférence inférieure à 1 m pour raccorder ladite pompe à vide à ladite chambre de traitement de semi-conducteurs et un conduit plus long pour raccorder ladite pompe à vide à ladite pompe de soufflante Roots et à ladite pompe primaire de sorte que ladite pompe de soufflante Roots et ladite pompe primaire soient situées à distance de ladite chambre de traitement de semi-conducteurs.

12. Procédé de vidage d'une chambre de traitement de semi-conducteurs, ledit procédé comprenant les étapes consistant à :
mettre en place une pompe à vide selon l'une quelconque des revendications 1 à 9 à l'intérieur d'une installation de fabrication de semi-conducteurs et raccorder ladite pompe à vide à une chambre de traitement de semi-conducteurs par un conduit de longueur inférieure à 2 m ;
mettre en place une pompe de soufflante Roots et une pompe primaire à une position à distance de l'installation de fabrication de semi-conducteurs et raccorder un orifice de sortie de ladite pompe à vide à un orifice d'entrée de ladite pompe de soufflante Roots par le biais d'un conduit plus long ;
mettre en œuvre lesdites pompes à vide pour vider ladite chambre de traitement de semi-conducteurs à un vide compris entre 1 mbar et 5 × 10⁻² mbar.
